Europäisches Patentamt

European Patent Office

Office européen des brevets

(·19)

Publication number: **0 290 127**

**A1**

## EUROPEAN PATENT APPLICATION

(21) Application number: 88302581.9

(22) Date of filing: 24.03.88

(51) Int. Cl.⁴ **H01L 39/24 , C23C 14/56**

(30) Priority: 06.05.87 US 47245

(43) Date of publication of application:
09.11.88 Bulletin 88/45

(84) Designated Contracting States:
AT BE CH DE ES FR GB GR IT LI LU NL SE

(71) Applicant: VARIAN ASSOCIATES, INC.
611 Hansen Way
Palo Alto, CA 94303(US)

(72) Inventor: Wickersham, Charles E., Jr.
571 Arden Road
Columbus Ohio, 43214(US)

(74) Representative: Cline, Roger Ledlie et al
EDWARD EVANS & CO. Chancery House
53-64 Chancery Lane
London WC2A 1SD(GB)

(54) Sputter manufacturing method for superconducting wire.

(57) A superconducting wire containing brittle super-conducting material is formed by passing a core filament (42) through a sequence of hollow cathode sputtering chambers (26,30) which, in turn, deposit a sequence of layers (44, 46) of superconducting and non-superconducting materials. The hollow cathode sputtering source makes efficient use of precious materials and coats the core uniformly.

FIG.2

# SPUTTER MANUFACTURING METHOD FOR SUPERCONDUCTING WIRE

This invention pertains to a method of manufacturing a wire for use in superconducting magnet devices.

New high temperature superconductor materials have recently been reported. (See S. W. Chu et al. Phy Rev. Lett., 58, pp. 405-407; R. J. Cava, Phys. Rev. Lett., 58, 407-410). These materials are brittle and unsuited for manufacturing into wires by conventional means.

Superconductivity was discovered in 1911, when Dutch Physicist Heike Onnes cooled the element mercury to near absolute zero (0° Kelvin, or -460°F) and discovered that it had lost its resistance to electric current. Since then more than two dozen chemical elements and hundreds of compounds have been found to be superconductors near that temperature extreme. The only practical way to make something that cold is to bathe it in liquid helium, which exists only at temperatures below 4°K. But helium is rare, and expensive to liquefy. (Liquid helium has a cost comparable to good Scotch whiskey.) Even so, the efficiency of electromagnets wound with superconducting wires is so great that in certain situations the expense is justified. For example, giant particle accelerators require extremely powerful magnets to keep the particles confined to a circular track as they move at nearly the speed of light. The superconducting super collider, a mammoth accelerator 52 miles in circumference, planned for completion in the 1990s at a projected cost of between $4 billion and $6 billion, will use 10,000 superconducting magnets and save nearly $600 million annually. In most uses, however, the cost of liquid helium outweighs the benefits of superconducting technology. For that reason, scientists have long searched for a compound that would become a superconductor at less extreme temperatures - particularly above 77°K (-320°F), the point at which nitrogen gas liquefies. Nitrogen is a common gas and costs no more than a tenth as much in liquid form as helium. (In fact, liquid nitrogen, priced as low as a nickel per liter, is cheaper than beer and comparable to bottled water.) The much sought-after goal proved to be elusive. In the early 1970s scientists found an alloy of niobium and germanium that lost all resistance at 23°K. Then, in April 1986, a group at Zurich in Switzerland announced development of a compound of barium, lanthanum, copper and oxygen that appeared to begin the transition to superconductivity at 35°K. Scientists have recently demonstrated superconductivity in exotic ceramic materials at 98°K. Superconductors which operate at even higher temperatures are possible, but finding the right combination of materials is tricky.

Fabricating these difficult materials into forms useful for applications is challenging.

Many scientists believe the discovery of high temperature superconductivity has begun an era of unprecedented rate of invention. Electric motors may become much smaller, perhaps a tenth of their current size. Electric cars beome a reasonable option. The Japanese have been working on a new railway design that uses electromagnets to levitate the train slightly above the tracks and propel it at super speeds; superconductivity could make such trains an affordable reality. Electricity could be stored in large magnets for use at times of peak demand, reducing the need to maintain often idle power-generating facilities. Magnets also might be used to contain fusion reactions to produce electricity using sea water for fuel. In medicine, superconductivity could provide better imaging technologies, identifying tumors without surgery. Computers could be made smaller and infinitely faster, increasing their ability to solve complex problems quickly. There could be large gains in national security. Superconductivity would vastly improve the efficiency of a strategic defense against nuclear weapons, computers would be able to pinpoint the targets more clearly, and dispatch interceptors or focus laser beams more quickly. An adaptation of the levitating railway could also be used to help launch rockets for civilian or military use by giving them an initial boost, much like catapults on aircraft carriers. Rockets would require less fuel and be able to carry substantially larger payloads. Just because a substance loses its electrical resistance when it's dipped in a cold, liquefied gas does not mean it will be much good in the real world. To be practical, superconductors have to be fashioned into wires, cores of magnets, and the thin coatings that form the foundation of computer cirouits. And the materials, which are basically ceramics, are brittle - and fragile. It is a long road between discovery and use of the devices.

The current commercial methods for manufacturing superconducting wire is to produce an ingot of the superconducting material, such as NbTi or NbSn, extrude this material into rods, combine the rods with copper or copper alloys and then draw/swage the billet into multifilament wire. (See E. Gregory, Journal of Metals, 36, #6, pp. 30-35, 1984). Sputtering has also been used to fabricate superconductors in electronic thin film devices and also for coating graphite filaments with superconducting NbN. (See M. Dietrich, Trans IEEE, MAG-21, pp. 455-458). However, the method of Dietrich used opposed planar magnetrons. This method is relatively inefficient and does not uniformly coat the filaments.

An object of the invention is to provide a method of efficiently manufacturing a wire of superconducting materials.

A further object of the invention is to provide a method of manufacturing the same wire in which layer thickness can be made uniform.

These objects of the invention and other objects, features and advantages to become apparent as the specification progresses are accomplished by the invention according to which, briefly stated, the wire is·manufactured in a machine having multiple hollow cathode sputter sources each for different materials. The wire passes serially through each hollow cathode sputter source in sequence and a layer of different materials is deposited uniformly at each source.

The superconducting wire manufactured according to the invention can be formed by sputter coating thin alternative layers of superconducting and a ductile normal metal such as copper on a high strength core such as tungsten. The use of thin alternating layers of superconducting and normal metal will greatly improve the ability of the completed wire to bend without fracturing brittle superconducting materials and also reduce the AC losses in the wire. The optimum performance for a given volume of coating is achieved when the superconducting layer thickness is a constant from layer to layer. This condition provides the lowest manufacturing cost since it consumes the minimum amount of material for sputtering.

These and further constructional and operational characteristics of the invention will be more evident from the detailed description given hereinafter with reference to the figures of the accompanying drawings which illustrate one preferred embodiment and alternatives by way of non-limiting examples.

FIG. 1a shows a diagram of a simple single fiber of a superconducting wire.

FIG. 1b shows multiple fibers of FIG. 1a assembled into a multifilament wire bundle.

FIG. 2 shows a sectional view of the fiber coating machine used in the invention.

FIG. 3 is a sectional diagram of a multilayered multifilament superconducting wire. FIG. 3a is a sectional diagram of a wire bundle. FIG. 3b is a sectional diagram of one composite wire of the bundle. FIG. 3c is a blowup of a section of one composite wire along the line 3C-3C shown in FIG. 3b to show the various layers.

The following is a glossary of terms, elements, and structural members as referenced and employed in the present invention. 10 simple single superconductor filament
12 filament core
14 superconductor layer

16 normal layer
18 wire bundle
20 fiber coating machine
22 supply reels
24 entrance lock
26 first hollow cathode sputter source
28 cryopump
30 isolation chamber
32 second sputter source
34 exit lock
36 take-up reels
38 multifilament multilayered wire bundle
40 multilayered filament
42 filament core
44 superconducting layers
46 normal layers
48 pair of sputtering sources

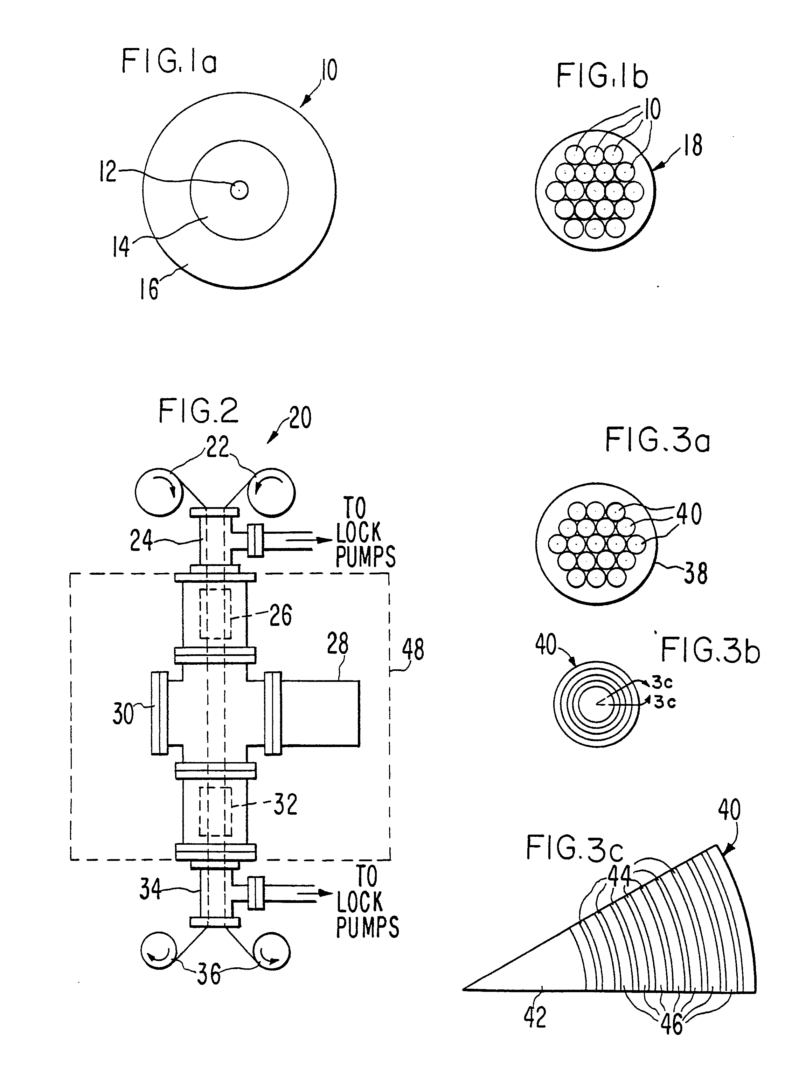

Referring now to the drawings wherein reference numerals are used to designate parts throughout the various figures thereof, there is shown in FIG. 1a a cross-section of a simple single filament 10 for a superconducting wire. A filament core 12 of material such as tungsten for strength is coated with a superconductor layer 14 of material such as NbSn, NbGe, YBaCuo,·a La-Ba-Cu-D compund or a La-Sr-Cu-D. A normal layer 16 of material such as copper for protection of the superconductor layer 14 is then deposited on top of the brittle superconductor layer 14. Multiple filaments 10 are formed into a wire bundle 18 for use in winding magnetic field generating coils, for example as shown in FIG.1b. In FIG. 2 there is shown a section of a fiber coating machine 20. Filament cores 12 are fed from supply reels 22 through an entrance lock 24. The entrance lock 24 is connected to lock pumps (not shown). The filament cores 12 are then fed through the center of a first hollow cathode sputter source 26 where a first layer of material such as the superconductor layer 14 is sputtered on the core 12. A cryopump 28 is used to evacuate an isolation chamber 30 between the first sputter source 26 and second hollow cathode sputter source 32. Another layer is deposited in the second sputter source 32 such as the top layer 16 in the example of FIG. 1a. The complete filament 10 is then passed through an exit lock 34 to a take-up reel 36. The exit lock 34 is evacuated by exit lock pumps (not shown).

Turning now to FIG. 3 there is shown a multifilament multilayered wire bundle 38, each filament 40 having a multiplicity of layers. A filament core 42 of high strength material such as tungsten is coated by use of the hollow cathode sputter sources as described above with multiple superconducting layers 44 of superconductor materials such as those cited above alternating with normal layers 46 of ductile material such as copper. To coat multiple layers additional cryopumps 28, isolation chambers 30, and pairs of sputtering sources 48 are added in series until the fier coating machine is capable of coating the desired sequence of layers. The layered structure 40 reduces stress in the superconducting coating and provides greater flexibility in the finished product, thereby permitting the multifilament, multilayered wire bundle 38 to be wound into coils.

The optimum performance for a given volume of superconducting material is achieved when the superconducting layer thickness is approximately from layer to layer. Each layer 44, 46 should be no less than 1000 Angstroms thick. The filament core 42 should be an approximately .0005″ (.0013cm) filament of high strength material such as tungsten. These conditions provide the lowest manufacturing cost since they consumes the minimum amount of material for sputtering. The hollow cathode sputtering source makes efficient use of precious materials and coats the core uniformly.

## Claims

1. A method of manufacturing a superconducting wire comprising:

passing a high strength core filament (12) through a hallow cathode sputter source (26) where superconductor material (14) is sputtered on said core filament to form a composite filament.

2. The method of claim 1 including a subsequent step of passing said composite filament (12, 14) through a second hollow cathode sputter source (32) where normal metal material (16) is sputter-deposited on said composite filament.

3. The method of claim 2 including subsequent steps of forming a multiplicity of alternating layers of superconducting materials (44) and normal materials (46) by sputtering in a hallow cathode source.

4. The method of claim 3 wherein each layer is formed to substantially the same thickness and each layer is formed to a thickness of no less than 1000 Angstroms ($10^{-4}$mm).

FIG.1a

FIG.1b

FIG.2

FIG.3a

FIG.3b

FIG.3c

TO LOCK PUMPS

TO LOCK PUMPS

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | CRYOGENICS, vol. 24, no. 11, November 1984, pages 636-638, Butterworth & Co. (Publishers) Ltd, Guildford, Surrey, GB; M. DIETRICH et al.: "Continuous production of NbN on carbon fibres by magnetron sputtering" * Page 636, paragraph 2; page 637, figure 1 * | 1 | H 01 L 39/24 C 23 C 14/56 |
| Y | JOURNAL OF APPLIED PHYSICS, vol. 40, no. 4, 15th March 1969, pages 1864-1869, New York, US; P.A. TURNER et al.: "Magnetic domain nucleation and propagation in fine wires" * Page 1869, appendix C * | 1 | |
| A | GB-A-1 425 754 (THE ELECTRICITY COUNCIL) * Page 2, column 1, lines 49-61; page 2, column 2, lines 127-130; claims 1,2 * | 2 | |
| A | US-A-4 043 888 (J.R. GAVALER) | | TECHNICAL FIELDS SEARCHED (Int. Cl.4) |
| A | THIN SOLID FILMS, vol. 115, no. 4, May 1984, pages 315-327, Elsevier Sequoia, Lausanne, CH; A. TERADA et al.: "The film growth process in the bias sputtering of superconducting Nb3Ge" | | H 01 L C 23 C |

The present search report has been drawn up for all claims

| Place of search | Date of completion of the search | Examiner |
|---|---|---|
| THE HAGUE | 10-08-1988 | JOFFREAU P.O. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                    

& : member of the same patent family, corresponding document

EPO FORM 1503 03.82 (P0401)